Europäisches Patentamt

European Patent Office

Office européen des brevets

(19)

(11) Numéro de publication : **0 288 401 B1**

(12)

# FASCICULE DE BREVET EUROPEEN

(45) Date de publication du fascicule du brevet :
08.01.92 Bulletin 92/02

(51) Int. Cl.⁵ : **H03L 7/14**

(21) Numéro de dépôt : **88420129.4**

(22) Date de dépôt : **21.04.88**

(54) **Générateur de fréquences de référence multiples.**

(30) Priorité : **24.04.87 FR 8705830**

(43) Date de publication de la demande :
**26.10.88 Bulletin 88/43**

(45) Mention de la délivrance du brevet :
**08.01.92 Bulletin 92/02**

(84) Etats contractants désignés :
**DE FR GB IT NL**

(56) Documents cités :
**EP-A- 0 200 847
US-A- 4 105 946
PATENT ABSTRACTS OF JAPAN, vol. 6, no.
155 (E-125)[1033], 17 août 1982; & JP-A-57 76
931 (DENKI KOGYO K.K.) 14-05-1982**

(73) Titulaire : **SGS-THOMSON
MICROELECTRONICS S.A.
7, Avenue Galliéni
F-94250 Gentilly (FR)**

(72) Inventeur : **Douziech, Patrick
Wilstorfstrasse 46
W-7730 VS Villingen (DE)**
Inventeur : **Berger, Philippe
Wilstorfstrasse 44
W-7730 VS Villingen (DE)**

(74) Mandataire : **de Beaumont, Michel et al
1bis, rue Champollion
F-38000 Grenoble (FR)**

## Description

La présente invention concerne les circuits de génération de fréquences de référence précises.

Un exemple d'application particulièrement concerné est la génération de fréquences de référence pour des modulateurs ou démodulateurs de signaux modulés en fréquence.

La présente invention a été réalisée à propos de circuits de modulation et de démodulation de signaux de luminance et de chrominance de télévision, notamment en vue de l'enregistrement de ces signaux par un magnétoscope.

Pour ces circuits on a besoin d'engendrer plusieurs fréquences précises correspondant à des valeurs normalisées pour les différents systèmes de transmission existants (PAL, SECAM, NTSC).

La manière normale d'engendrer ces fréquences précises est d'utiliser des oscillateurs à quartz avec un quartz spécifique pour chacune des fréquences à engendrer. Mais cette méthode est coûteuse, surtout du fait que les quartz sont des éléments extérieurs aux circuits-intégrés dans lesquels les fréquences de référence sont utilisées.

Une autre méthode consiste à utiliser un seul quartz et des circuits logiques de comptage, de division de fréquences, de conversion numérique-analogique etc., pour engendrer plusieurs fréquences différentes : par exemple la fréquence d'oscillation du quartz peut être divisée pour définir un temps étalon assez grand par rapport à la fréquence du quartz ; un oscillateur contrôlé par une tension fournit un signal ayant la fréquence désirée ; pour que cet oscillateur fournisse bien la fréquence désirée, différente de celle du quartz, on compte combien de périodes d'oscillations il émet pendant le temps étalon défini par le quartz et les diviseurs ; le nombre de périodes est comparé à une valeur réglable programmée (cette valeur permet de définir les différentes fréquences de sortie désirées) ; le résultat de la comparaison sert à incrémenter un compteur dont la sortie commande un convertisseur numérique-analogique. Le convertisseur pilote l'oscillateur pour ajuster sa fréquence de sortie à une valeur qui est donc liée à la valeur réglable programmée.

Ce type de solution est coûteux en surface de circuit intégré compte-tenu du grand nombre de circuits relativement complexes à prévoir (compteurs, diviseurs, convertisseurs).

L'invention propose une nouvelle structure de circuit de génération de fréquences précises qui évite ces inconvénients.

Le générateur selon l'invention, qui utilise une seule fréquence de référence, comprend un oscillateur à fréquence contrôlable par un courant, un comparateur de phase recevant d'une part la fréquence de référence et d'autre part la sortie de l'oscillateur, et une boucle d'asservissement reliant la sortie du comparateur de phase à une entrée de commande de l'oscillateur, cette boucle comportant une capacité de filtrage. La boucle comporte en outre un interrupteur pour ouvrir la boucle, cet interrupteur étant placé entre la sortie du comparateur de phase et la capacité, et un générateur de courant commandé par une tension, capable d'engendrer sur sa sortie un courant variable en fonction d'une tension de commande et inversement proportionnel à la valeur d'une résistance. La résistance est construite sous forme d'un réseau de résistances et d'interrupteurs, avec un moyen de commande des interrupteurs pour ajuster la valeur globale de la résistance à une valeur désirée. Le courant de sortie du générateur est appliqué à l'entrée de commande de l'oscillateur et la tension aux bornes de la capacité est appliquée à l'entrée du générateur de courant.

On peut construire relativement facilement en technologie de circuit-intégré bipolaire un générateur de courant commandé par une tension et dont le courant de sortie est inversement proportionnel à une résistance.

De plus on sait bien faire des oscillateurs à fréquence contrôlable par un courant. Ce qu'on appelle en général oscillateur contrôlé par une tension (VCO de l'anglais "voltage controlled oscillator") est d'ailleurs souvent réalisé sous forme d'un oscillateur contrôlé par un courant. La fréquence de sortie est proportionnelle au courant de commande dans la plage de fonctionnement normale de l'oscillateur.

Le circuit fonctionne alors globalement comme suit :

— dans une première phase on ferme la boucle d'asservissement et on donne une première valeur de résistance R0 au réseau. L'asservissement impose alors

— que l'oscillateur oscille à la fréquence de référence F0,

— que la capacité se charge à une valeur de tension V0 telle que le courant I0 qui en résulte alors dans le réseau de résistances corresponde au courant de commande nécessaire pour que l'oscillateur oscille à la fréquence F0.

— dans une deuxième phase, on ouvre la boucle d'asservissement ; la capacité fournit cependant toujours la tension V0 précédement établie ; on donne une autre valeur de résistance R1 au réseau ; il en résulte un courant I1 pour commander l'oscillateur et donc une fréquence de sortie F1.

Si le courant de commande de l'oscillateur est inversement proportionnel à la valeur de résistance globale du réseau et proportionnel à la fréquence d'oscillation, on a alors :

$$F1 = F0 \cdot R0/R1$$

Pour établir une fréquence de sortie quelconque à partir de la fréquence de référence unique F0, il suffit de donner au réseau de résistances une valeur de résistance globale dont le rapport relativement à R0 est le même que le rapport entre la fréquence de référence et la fréquence de sortie désirée.

Les technologies de circuits-intégrés bipolaires sont bien adaptées pour la réalisation de résistances dont on ne connaît pas avec certitude la valeur mais dont on connaît bien les valeurs relatives mutuelles si elles sont réalisées sur une même puce de circuit.

On aboutit donc selon l'invention à convertir un rapport de valeurs de résistances, bien maîtrisé, en un rapport de valeurs de fréquences. Une seule fréquence de référence est nécessaire et autant de fréquences de sortie que l'on désire peuvent être produites. Ces fréquences n'apparaissent pas simultanément mais séquentiellement à la sortie du générateur selon l'invention, et ceci seulement pendant la deuxième phase mentionnée ci-dessus. Si l'on veut plusieurs fréquences simultanées il faut plusieurs générateurs selon l'invention, mais bien entendu ces générateurs pourront utiliser tous la même fréquence de référence donc un quartz unique.

D'autres caractéristiques et avantages de l'invention apparaîtront à la lecture de la description détaillée qui suit et qui est faite en référence aux dessins annexés dans lesquels :

— la figure 1 représente un schéma synoptique du générateur de fréquences selon l'invention ;

— la figure 2 représente un exemple simplifié de réalisation du générateur de courant du schéma de la figure 1 ;

— la figure 3 représente un autre exemple de réalisation du générateur de courant ;

— la figure 4 est un schéma détaillé d'oscillateur commandable par une tension ou un courant ;

— la figure 5 représente un schéma de circuit détaillé d'un mode de réalisation du générateur de fréquences selon l'invention.

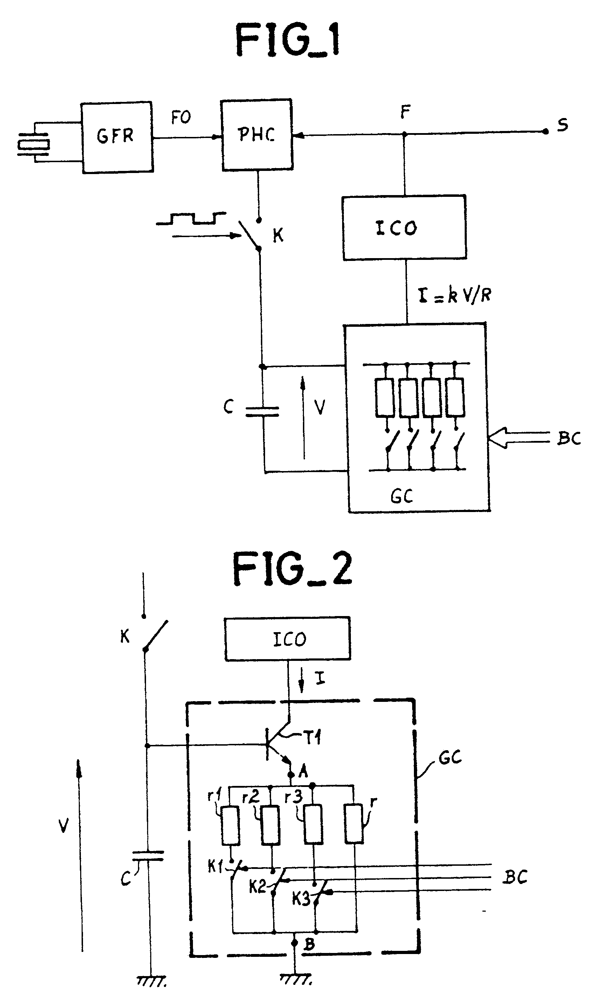

Le schéma bloc de la figure 1 représente les composants principaux du générateur de fréquences selon l'invention.

Ces composants sont les suivants :

— un comparateur de phase PHC,

— un oscillateur à fréquence commandée par un courant, ICO,

— un générateur de courant, GC, commandé par une tension, et dont le courant de sortie est inversement proportionnel à la valeur d'une résistance,

— une capacité C,

— un interrupteur K.

L'oscillateur ICO, le comparateur de phase PHC, le générateur de courant GC et la capacité C constituent ensemble une boucle d'asservissement de phase par laquelle la fréquence de sortie F du générateur s'ajuste sur une fréquence de référence F0 fournie au comparateur de phase PHC.

La fréquence de référence est fournie soit à partir de l'extérieur du circuit-intégré sur lequel est en principe réalisée l'invention, soit à l'intérieur de ce circuit-intégré. Dans l'exemple représenté, la fréquence de référence F0 est fournie par un oscillateur GFR intérieur au circuit-intégré, associé à un quartz extérieur.

Le comparateur de phase reçoit à la fois la fréquence de référence F0 et la fréquence de sortie de l'oscillateur ICO. Il fournit un courant de sortie représentant l'écart de phase entre ces deux fréquences. Ce courant est appliqué à travers l'interrupteur K à la capacité C qui sert classiquement à lisser les variations de courant et qui servira ici à stocker la tension de sortie engendrée par le comparateur de phase lorsque la boucle d'asservissement fonctionne (interrupteur K fermé) et à la conserver un certain temps même après ouverture de la boucle.

La tension V aux bornes de la capacité est appliquée comme signal d'entrée au générateur de courant GC dont le courant de sortie se trouve de ce fait commandé par la tension V.

On peut supposer dans la suite qu'il y a proportionnalité entre le courant de sortie I du générateur GC et la tension V mais le circuit fonctionne aussi bien si ce n'est pas le cas. Il faut simplement que le courant varie avec la tension dans un sens compatible avec l'asservissement, c'est-à-dire que si un écart de phase entre les entrées du comparateur PHC tend à augmenter la tension V, il faut que le courant I et la fréquence F engendrée par ce courant tendent à réduire l'écart de phase.

Le courant de sortie I est appliqué comme courant de commande à l'oscillateur ICO dont la fréquence de sortie F est proportionnelle au courant I. La fréquence de sortie peut aussi être inversement proportionnelle au courant de sortie sans changer le principe de l'invention.

De plus, le générateur de courant GC comporte une résistance de valeur R et son courant de sortie I est inversement proportionnel à cette valeur R. La résistance est construite sous forme d'un réseau de résistances commutables par des interrupteurs, et les interrupteurs sont commandés pour faire varier la valeur R. La manière la plus simple d'établir ce réseau est d'utiliser plusieurs résistances en parallèle, chacune en série avec un interrupteur respectif, comme cela est schématisé sur la figure 1.

Les interrupteurs du réseau de résistances sont commandés par un bus de conducteurs BC (un seul conducteur s'il n'y a qu'un interrupteur, c'est-à-dire dans le cas limite où on ne veut qu'une seule fréquence de sortie différente de la fréquence du quartz).

Le détail du fonctionnement est le suivant :

Dans une phase préliminaire, l'interrupteur K est fermé et la boucle d'asservissement fonctionne. La fréquence de sortie de l'oscillateur ICO s'ajuste sur la fréquence de référence F0 et la capacité C se charge à une valeur de potentiel V. Le courant de commande de l'oscillateur ICO (c'est-à-dire aussi le courant de sortie du générateur GC) est I0. Pendant cette phase, le bus de commande BC fournit des signaux de commande tels que la valeur de résistance du réseau appartenant au générateur GC soit R0.

Dans une deuxième phase, on ouvre l'interrupteur K et on applique par le bus BC des signaux de commande des interrupteurs du réseau de résistances de telle sorte que la résistance globale prenne une valeur R1. La tension V aux bornes de la capacité C reste constante si on prévoit que l'entrée du générateur de courant GC présente une impédance suffisamment haute. Le générateur GC fournit alors à sa sortie un courant I tel que $I = I0 \cdot R0/R1$. L'oscillateur ICO modifie sa fréquence de sortie qui devient $F1 = F0 \cdot R0/R1$ (si la fréquence est proportionnelle au courant de commande).

On a ainsi obtenu une fréquence de sortie F proportionnelle à une fréquence de référence stable F0 (donnée par un quartz) et proportionnelle à un rapport de résistances.

Pour obtenir une autre fréquence, on répète la première phase avec une valeur de résistances rétablie à R0, puis on répète à nouveau une deuxième phase avec une résistance de valeur R2. La répétition de la première phase n'est d'ailleurs pas strictement nécessaire si la capacité C n'a pas eu le temps de se décharger pendant la phase de production de la première fréquence.

On va maintenant indiquer comment on peut réaliser pratiquement le générateur de courant GC.

La figure 2 en montre un exemple simplifié : le générateur est simplement constitué par

— d'une part un groupe de résistances susceptibles d'être mises en parallèle les unes avec les autres grâce à des interrupteurs en série avec chacune des résistances,

— et d'autre part un transistor amplificateur en série avec le groupe de résistances.

A titre d'exemple on a représenté quatre résistances, susceptibles d'être mises en parallèle entre deux bornes A et B, la résistance vue entre les bornes A et B étant celle qui définit le courant de sortie du générateur GC. Une des résistances, désignée par r, est connectée en permanence entre les bornes A et B ; les autres, r1, r2, r3, ont chacune une extrémité reliée à la borne A et une autre extrémité reliée à un interrupteur respectif, K1, K2, K3. Les interrupteurs sont commandés individuellement par le bus BC pour mettre en parallèle avec la résistance r une ou plusieurs des autres résistances et ainsi modifier la résistance vue entre les bornes A et B.

La borne B est reliée à la masse et la borne A est reliée à l'émetteur d'un transistor T1 dont le collecteur constitue la sortie du générateur de courant GC. La base du transistor T1 est reliée à une borne de la capacité C, l'autre borne de la capacité étant reliée à la masse.

Le transistor T1 agit comme amplificateur monté en émetteur suiveur. Si le transistor a un gain suffisant, le courant de sortie I du générateur GC est pratiquement le courant circulant dans l'émetteur du transistor T1 et ce courant est égal à (V-Vbe)/R, R étant la résistance vue entre les bornes A et B et Vbe étant la chute de tension base-émetteur du transistor T1 ; cette chute de tension Vbe est pratiquement indépendante du courant I, de sorte qu'on a réalisé de manière très simple un générateur de courant commandé par la tension V et inversement proportionnel à une valeur de résistance. Pour réduire le courant de décharge de la capacité C, on peut connecter en série entre la capacité C et la base du transistor T1 un étage de préamplification à grande impédance d'entrée.

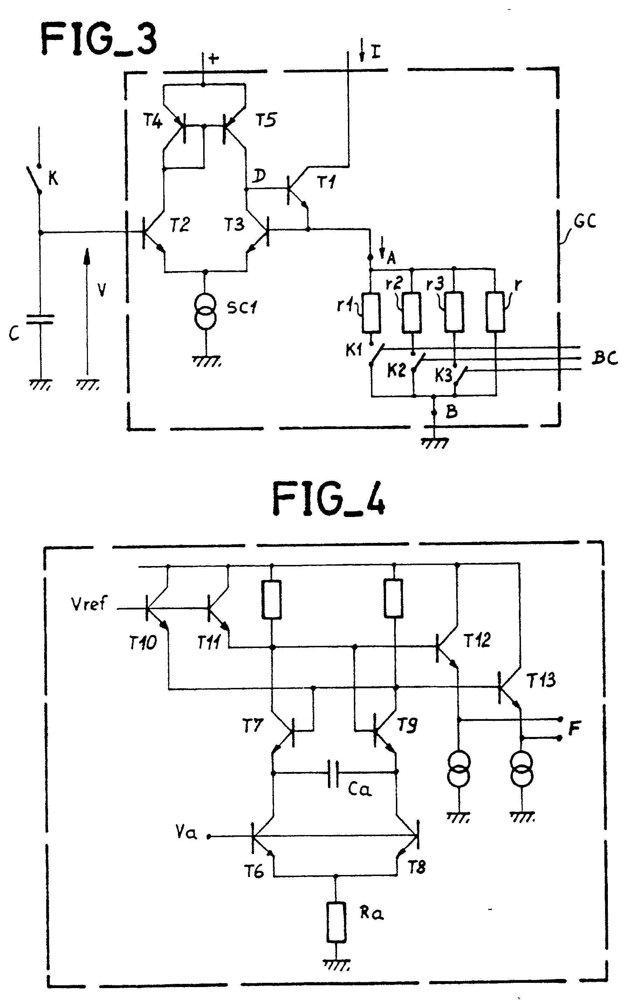

La figure 3 représente une variante de réalisation plus sophistiquée du générateur de courant GC, cette variante prenant en compte les variations de la chute de tension Vbe en fonction du courant I puisque ces variations se traduisent par un défaut de proportionalité entre le courant I et la conductance vue entre les bornes A et B à tension V constante.

Sur la figure 3, la capacité C est reliée à une première entrée d'un étage amplificateur différentiel à quatre transistors T2, T3, T4, T5 et une source de courant SC1 ; la sortie D de cet étage est reliée à la base d'un transistor T1 ayant la même fonction que le transistor T1 de la figure 2 ; par ailleurs, la borne A, c'est à dire l'émetteur du transistor T1 est reliée à une deuxième entrée de l'amplificateur différentiel. Ici, la première entrée est constituée par la base du transistor T2 et la deuxième par la base du transistor T3, la sortie de l'étage étant prise sur le collecteur de T3.

Par ce montage en forme d'asservissement, l'écart de tension entre les deux entrées de l'étage différentiel tend à se maintenir à zéro (d'autant plus que le gain de cet étage est plus élevé), de sorte que le potentiel de la borne A tend à suivre exactement le potentiel V appliqué à la première entrée de l'étage. Même s'il subsiste un certain écarte entre ces potentiels, cet écart est minime et indépendant du courant qui traverse le transistor.

L'oscillateur commandé en courant est réalisé à partir d'un oscillateur commandé en tension de constitution classique tel que celui représenté dans le cadre tireté de la figure 4. Il comprend deux branches différentielles comportant l'une deux transistors en série T6 et T7, l'autre deux transistors en série T8 et T9 ; ces deux branches sont réunies à une résistance Ra à travers laquelle passe la somme des courants circulant dans les deux branches ; une capacité Ca relie les collecteurs des transistors T6 et T8. Les bases des transistors T6 et T8 sont reliées l'une à l'autre. La base du transistor T7 est reliée au collecteur du transistor T9 et réciproquement. D'autres transistors T10 et T11 sont prévus pour la polarisation des bases et collecteurs des transistors T7 et T9. Enfin deux transistors T12 et T13 servent d'amplificateurs montés en collecteur commun, leurs bases étant reliées aux collecteurs des transistors T7 et T9 ; la sortie de l'oscillateur est une sortie différentielle prélevée sur les émetteurs de T12 et T13.

Ce montage constitue un oscillateur commandé en courant ou en tension : la tension de commande serait le potentiel Va appliqué aux bases des transistors T6 et T8 ; le courant de commande est le courant circulant dans la résistance Ra, c'est-à-dire aussi le courant circulant se partageant entre les transistors T6 et T8.

C'est pourquoi, de manière avantageuse, on associe l'oscillateur commandé en courant ICO et le générateur de courant GC de la manière suivante : le transistor T6 de la figure 4 est constitué par le transistor T1 de la figure 3, et de même la résistance Ra de la figure 4 est constituée par le réseau de résistances r, r1, r2, r3, de la figure 3.

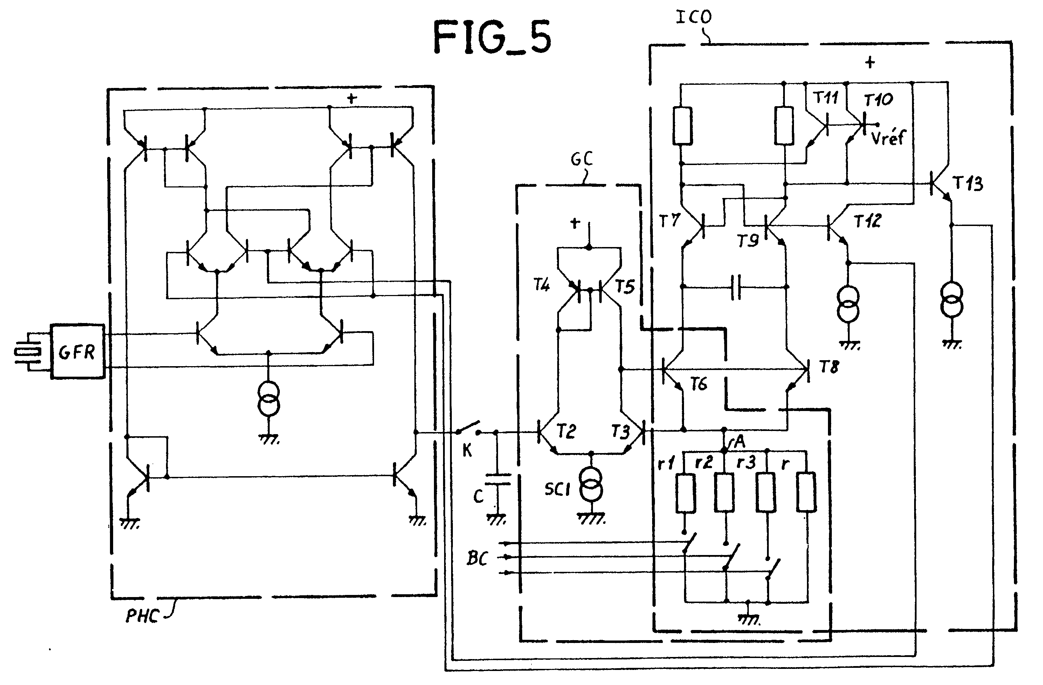

La figure 5 montre enfin un exemple de réalisation détaillé pour l'ensemble du circuit de génération de fréquence selon l'invention. Dans cet exemple, on utilise l'oscillateur contrôlé en courant de la figure 4 et le générateur de courant de commande de la figure 3, associés comme indiqué ci-dessus, et un comparateur de phase de type classique dans le détail duquel il n'est pas nécessaire d'entrer.

## Revendications

1. Générateur de fréquences précises utilisant une seule fréquence de référence (F0), comprenant un oscillateur à fréquence contrôlable par un courant (ICO), un comparateur de phase (PHC) recevant d'une part la fréquence de référence et d'autre part la sortie de l'oscillateur, et une boucle d'asservissement reliant la sortie du comparateur de phase à une entrée de commande de l'oscillateur, cette boucle comportant une capacité de filtrage (C), caractérisé en ce que la boucle comporte en outre un interrupteur (K) pour ouvrir la boucle, cet interrupteur étant placé entre la sortie du comparateur de phase et la capacité, et un générateur de courant commandé par une tension (GC), capable d'engendrer sur sa sortie un courant variable en fonction d'une tension de commande (V) et inversement proportionnel à la valeur d'une résistance, la résistance étant construite sous forme d'un réseau de résistances (r, r1, r2, r3) et d'interrupteurs (K1, K2, K3), avec un moyen de commande des interrupteurs pour ajuster la valeur globale de la résistance à une valeur désirée, le courant de sortie du générateur étant appliqué à l'entrée de commande de l'oscillateur et la tension aux bornes de la capacité étant appliquée à l'entrée du générateur de courant.

2. Générateur de fréquences selon la revendication 1, caractérisé en ce que le générateur de courant de commande comprend un transistor (T1) dont le collecteur fournit le courant de commande, dont la base reçoit une tension de commande, et dont l'émetteur est relié au réseau de résistances.

3. Générateur de fréquences selon la revendication 2, caractérisé en ce que le générateur de courant de commande comprend un étage d'amplification différentielle (T2, T3, T4, T5) dont une première entrée est reliée à la capacité, dont une deuxième entrée est reliée à l'émetteur du transistor (T1), et dont la sortie est reliée à la base du transistor.

## Claims

1. An accurate frequency generator using a single reference frequency (F0) comprising a current controlled oscillator (ICO), a phase comparator (PHC) receiving on the one hand the reference frequency and on the other hand the oscillator output, and a loop connecting the phase comparator output with a control input of the oscillator, this loop comprising a filtering capacitor (C), characterized in this that the loop further comprises a switch (K) for opening the loop, this switch being arranged between the output of the phase comparator and the capacitor, and a voltage controlled current generator (GC), capable of generating on its output a variable current as a function of a control voltage and reversely proportional to a resistor value, the resistor corresponding to an array of resistors (r, r1, r2, r3) and switches (K1, K2, K3) with means for controlling the switches for adjusting the net value of the resistor to a desired value, the output current of the generator being applied to the control input of the oscillator and the voltage across the capacitor being applied to the input of the current generator.

2. A frequency generator according to claim 1, characterized in this that the control current generator comprises a transistor (T1), the collector of which provides the control current, the base of which receives a control voltage, and the emitter of which is connected with the resistor array.

3. A frequency generator according to claim 2, characterized in this that the control current generator comprises a differential amplification stage (T2, T3, T4, T5), a first input of which is connected with the capacitor, the second input of which is connected with the emitter of said transistor (T1) and the output of which is connected with the base of said transistor.

## Patentansprüche

1. Frequenzgenerator zur Erzeugung exakter Frequenzen unter Verwendung einer einzigen Bezugsfrequenz (F0), mit einem stromgesteuerten Frequenzoszillator (ICO), einem Phasenkomparator (PHC), dem einerseits die Bezugsfrequenz und anderseits das Oszillatorausgangssignal zugeführt wird, und mit einem Rückkopplungkreis, der den Phasenkomparatorausgang mit einem Steuereingang des Oszillators verbindet, wobei dieser Kreis einen Filterkondensator (C) aufweist, dadurch gekennzeichnet, daß der Kreis weiterhin einen zwischen dem Ausgang des Phasenkomparators und dem Kondensator angeordneten Schalter (K) zum Öffnen des Kreises sowie einen spannungsgesteuerten Stromgenerator (GC) aufweist, der dazu ausgelegt ist, an seinem Ausgang einen in Abhängigkeit von einer Steuerspannung (V) variablen Strom zu erzeugen, der umgekehrt proportional zu einem Widerstandswert ist, wobei der Widerstand gebildet ist aus einer Anordnung von Widerständen (r, r1, r2, r3) und Schaltern (K1, K2, K3) mit einer Einrichtung zum Steuern der Schalter zum Einstellen des Gesamtwiderstandswerts auf einen gewünschten Wert, wobei der Ausgangsstrom des Generators dem Steuereingang des Oszillators zugeführt wird und die an dem Kondensator anliegende Spannung dem Eingang des Stromgenerators zugeführt wird.

2. Frequenzgenerator nach Anspruch 1, dadurch gekennzeichnet, daß der Steuerstromgenerator einen Transistor (T) aufweist, dessen Kollektor den Steuerstrom liefert, dessen Basis eine Steuerspannung zugeführt wird und dessen Emitter mit der Widerstandsanordnung verbunden ist.

3. Frequenzgenerator nach Anspruch 2, dadurch gekennzeichnet, daß der Steuerstromgenerator eine Differenzverstärkerstufe (T2, T3, T4, T5) aufweist, deren erster Eingang mit dem Kondensator verbunden ist, deren zweiter Eingang mit dem Emitter des Transistors (T1) verbunden ist und deren Ausgang mit der Basis des Transistors verbunden ist.

# FIG_1

# FIG_2

7

# FIG_3

# FIG_4

8

FIG_5

ICO

GC

PHC

GFR

T4 T5
T2 T3
T6 T7 T8 T9
T10 T11 T12 T13
Vréf

K
C
SCI
BC

r1 r2 r3 r
rA

EP 0 288 401 B1